# EUROPEAN PATENT APPLICATION

(11) **EP 4 509 919 A1**
(43) Date of publication of application: **19.02.2025**
(21) Application number: 22936722.2
(22) Date of filing: 19.10.2022
(51) Int. Cl.: G03F 1/00, G03F 1/68, G02F 1/01, G02F 1/15, G02F 1/163

(54) **MASK, PHOTOLITHOGRAPHY APPARATUS AND METHOD FOR MANUFACTURING MASK**

(30) Priority: 11.04.2022 CN 202210373942
(71) Applicant: Westlake University, Hangzhou, Zhejiang 310024 (CN)
(72) Inventor: LI, Xijun, Hangzhou, Zhejiang 310024 (CN)
(74) Representative: Meissner Bolte Partnerschaft mbB
(86) International application number: PCT/CN2022/126140
(87) International publication number: WO 2023/197552

(57) **Abstract**

A mask (100), a lithographing apparatus, and a method for manufacturing a mask (100), wherein the mask (100) includes: an electrolytic reaction layer (110) including an electrochromic material; a first control circuit layer (120) provided on a first side of the electrolytic reaction layer (110) and including a plurality of first control electrodes (121, H1, H2, H3, H4); and a second control circuit layer (130) provided on a second side of the electrolytic reaction layer (110) that is opposite to the first side and including a plurality of second control electrodes (131, V1, V2, V3, V4), wherein a light-transmitting state of a pixel region in the mask (100) is configured to be decided by a control voltage between at least a part of the first control electrode (121, H1, H2, H3, H4) and at least a part of the second control electrode (131, V1, V2, V3, V4) contained in the pixel region, and the control voltage controls the light-transmitting state of the pixel region by controlling an ion-bonding state of the electrochromic material in the electrolytic reaction layer (110).

## Description

### CROSS-REFERENCE TO RELATED APPLICATIONS

The present application claims the priority to the Chinese Patent Application No. 202210373942.9 entitled "MASK, LITHOGRAPHING APPARATUS AND METHOD FOR MANUFACTURING MASK" filed on April 11, 2022, the disclosure of which is incorporated by reference herein in its entirety.

### TECHNICAL FIELD

The present disclosure generally relates to the technical field of lithography, and more particularly, to a mask, a lithographing apparatus, and a method for manufacturing a mask.

### BACKGROUND

In the lithography technology, a patterned structure is typically formed using a mask. However, once the mask is prepared, the pattern thereon is not easy to be altered. Moreover, if a defect is present in the mask or introduced during the process of the use of the mask, it is difficult to repair the defect. In addition, the mask typically has a high cost. These above factors all can lead to an increase in the cost of the chip produced using the mask, and the complicated process due to monitoring of the mask defect. Therefore, there is a need for a new mask in the chip production technology.

### SUMMARY

An objective of the present disclosure is to provide a mask, a lithographing apparatus and a method for manufacturing a mask.

According to a first aspect of the present disclosure, there is provided a mask, comprising an electrolytic reaction layer comprising an electrochromic material; a first control circuit layer provided on a first side of the electrolytic reaction layer, and the first control circuit layer comprising a plurality of first control electrodes; and a second control circuit layer provided on a second side of the electrolytic reaction layer that is opposite to the first side, and the second control circuit layer comprising a plurality of second control electrodes, wherein a light-transmitting state of a pixel region in the mask is configured to be decided by a control voltage between at least a part of the first control electrode and at least a part of the second control electrode contained in the pixel region, and the control voltage controls the light-transmitting state of the pixel region by controlling an ion-bonding state of the electrochromic material in the electrolytic reaction layer.

In some embodiments, the mask further comprises: a substrate, on which the first control circuit layer, the electrolytic reaction layer, and the second control circuit layer are sequentially deposited.

In some embodiments, the substrate comprises at least one of quartz or calcium fluoride.

In some embodiments, the electrolytic reaction layer comprises: an electrolyte layer; a first electrolytic material layer provided between the first control circuit layer and the electrolyte layer; and a second electrolytic material layer provided between the electrolyte layer and the second control circuit layer.

In some embodiments, at least one of lithium ions or hydrogen ions are dissolvable in the electrolyte layer.

In some embodiments, the electrolyte layer comprises solid electrolyte; or the electrolyte layer comprises liquid electrolyte.

In some embodiments, one of the first electrolytic material layer and the second electrolytic material layer comprises the electrochromic material.

In some embodiments, one of the first electrolytic material layer and the second electrolytic material layer comprises magnesium nickel alloy, magnesium yttrium alloy, niobium oxide, or niobium oxide modified by indium tin oxide nanoparticles.

In some embodiments, another of the first electrolytic material layer and the second electrolytic material layer comprises transition metal oxide.

In some embodiments, another of the first electrolytic material layer and the second electrolytic material layer comprises wolfram oxide.

In some embodiments, the electrolyte layer comprises an electrolyte material in a shape of a continuous film; the first electrolytic material layer comprises a first electrolytic material in a shape of a continuous film; and/or the second electrolytic material layer comprises a second electrolytic material in a shape of a continuous film.

In some embodiments, the electrolyte layer comprises a plurality of electrolyte material blocks arranged in an array, and each pixel region in the mask comprises one or more electrolyte material blocks; the first electrolytic material layer comprises a plurality of first electrolytic material blocks arranged in an array, and each pixel region in the mask comprises one or more first electrolytic material blocks; and/or the second electrolytic material layer comprises a plurality of second electrolytic material blocks arranged in an array, and each pixel region in the mask comprises one or more second electrolytic material blocks.

In some embodiments, each of the plurality of first control electrodes is respectively connected to a first pole of a control power supply via a respective first switching device; and each of the plurality of second control electrodes is respectively connected to a second pole of the control power supply via a respective second switching device.

In some embodiments, each first control electrode is respectively configured to receive a first control signal, and each second control electrode is respectively configured to receive a second control signal, to control the light-transmitting state of the pixel region containing at least a part of the first control electrode and at least a part of the second control electrode that are overlapped.

In some embodiments, the first control electrode is a first strip electrode extending in a first direction, and the plurality of first control electrodes are arranged in the first control circuit layer in electrical isolation from each other; and the second control electrode is a second strip electrode extending in a second direction perpendicular to the first direction, and the plurality of second control electrodes are arranged in the second control circuit layer in electrical isolation from each other.

In some embodiments, each pixel region in the mask comprises at least a part of one first control electrode and at least a part of one second control electrode.

In some embodiments, each pixel region in the mask comprises at least a part of more than one first control electrodes and at least a part of more than one second control electrodes.

In some embodiments, a ratio of an area of a region occupied by the first control electrodes to an area of a region not occupied by the first control electrodes in the first control circuit layer is 100%~1000%; and/or a ratio of an area of a region occupied by the second control electrodes to an area of a region not occupied by the second control electrodes in the second control circuit layer is 100%~1000%.

In some embodiments, the ratio of the area of the region occupied by the first control electrodes to the area of the region not occupied by the first control electrodes in the first control circuit layer is equal to the ratio of the area of the region occupied by the second control electrodes to the area of the region not occupied by the second control electrodes in the second control circuit layer.

In some embodiments, the plurality of first control electrodes in the first control circuit layer are periodically arranged; and/or the plurality of second control electrodes in the second control circuit layer are periodically arranged.

In some embodiments, an arrangement period of the plurality of first control electrodes in the first control circuit layer is 50 nm~50 µm; and/or an arrangement period of the plurality of second control electrodes in the second control circuit layer is 50 nm~50 µm.

In some embodiments, the arrangement period of the plurality of first control electrodes in the first control circuit layer is equal to the arrangement period of the plurality of second control electrodes in the second control circuit layer.

In some embodiments, the first control electrode comprises at least one of indium tin oxide, aluminum-doped zinc oxide, conductive diamond, or conductive aluminum nitride; and/or the second control electrode comprises at least one of indium tin oxide, aluminum-doped zinc oxide, conductive diamond, or conductive aluminum nitride.

In some embodiments, a thickness of the first control circuit layer is 10 nm~100 nm; and/or a thickness of the second control circuit layer is 10 nm~100 nm.

In some embodiments, a resistivity of the first control electrode is less than that of the electrolytic reaction layer; and a resistivity of the second control electrode is less than that of the electrolytic reaction layer.

In some embodiments, a total thickness of the electrolytic reaction layer, the first control circuit layer, and the second control circuit layer is below 100 µm.

According to a second aspect of the present disclosure, there is provided a lithographing apparatus comprising: a mask as described above; and a control module configured to generate, according to a layout, a plurality of first control signals applied to the plurality of first control electrodes and a plurality of second control signals applied to the plurality of second control electrodes, respectively, so that light-transmitting states of pixel regions in the mask correspond to the layout.

According to a third aspect of the present disclosure, there is provided a method for manufacturing a mask, comprising: providing a substrate; forming a patterned first control circuit layer on the substrate, the first control circuit layer comprising a plurality of first control electrodes; forming an electrolytic reaction layer comprising an electrochromic material on the first control circuit layer; and forming a patterned second control circuit layer on the electrolytic reaction layer, the second control circuit layer comprising a plurality of second control electrodes; wherein a light-transmitting state of a pixel region in the mask is configured to be decided by a control voltage between at least a part of the first control electrode and at least a part of the second control electrode contained in the pixel region, and the control voltage controls the light-transmitting state of the pixel region by controlling an ion-bonding state of the electrochromic material in the electrolytic reaction layer.

In some embodiments, forming the electrolytic reaction layer on the first control circuit layer comprises: sequentially laminating a first electrolytic material layer, an electrolyte layer and a second electrolytic material layer together to form the electrolytic reaction layer; and forming the electrolytic reaction layer on the first control circuit layer, wherein the first electrolytic material layer is located between the first control circuit layer and the electrolyte layer.

In some embodiments, forming the electrolytic reaction layer on the first control circuit layer comprises: forming a first electrolytic material layer on the first control circuit layer; forming an electrolyte layer on the first electrolytic material layer; and forming a second electrolytic material layer on the electrolyte layer.

### BRIEF DESCRIPTION OF THE DRAWINGS

The accompanying drawings, which constitute a part of this specification, illustrate the embodiments of the present disclosure and serve to explain the principle of the present disclosure together with the description.

The present disclosure may be more clearly understood from the following detailed description taken in conjunction with the accompanying drawings, in which:
Fig. 1 is a structural schematic diagram of a mask according to an exemplary embodiment of the present disclosure;
Fig. 2 is a schematic diagram of a control circuit including a first control circuit layer and a second control circuit layer according to an exemplary embodiment of the present disclosure;
Fig. 3 is a schematic diagram of a state of a control circuit for regulating light-transmitting states of pixel regions of a mask;
Fig. 4 is a schematic diagram of the light-transmitting states of the pixel regions of the mask in the state of the control circuit of Fig. 3;
Fig. 5 is a schematic diagram of another state of the control circuit for regulating light-transmitting states of pixel regions of the mask;
Fig. 6 is a schematic diagram of the light-transmitting states of the pixel regions of the mask in the state of the control circuit of Fig. 5;
Fig. 7 is a structural schematic diagram of a lithographing apparatus according to an exemplary embodiment of the present disclosure;
Fig. 8 is a flow schematic diagram of a method for manufacturing a mask according to an exemplary embodiment of the present disclosure.

### DETAILED DESCRIPTION

The present disclosure will be described below with reference to the accompanying drawings, which illustrate several embodiments of the present disclosure. However, it should be understood that the present disclosure may be presented in many different ways and is not limited to the embodiments described below; and actually, the embodiments described below are intended to make the disclosure of the present disclosure more complete, and to fully convey the scope of protection of the present disclosure to those skilled in the art. It should also be understood that the embodiments disclosed herein can be combined in various ways so that more additional embodiments are provided.

It should be understood that in all the drawings, identical reference numerals denote identical elements. In the drawings, the size of a certain feature may be deformed for clarity.

It should be understood that the terminology in the description is only used for describing a specific embodiment, and is not intended to limit the present disclosure. All terminologies (including technical and scientific terminologies) used in the description have meanings commonly understood by those skilled in the art, unless otherwise defined. A well-known function or structure may not be described in detail for brevity and/or clarity.

The terminologies "comprise", "include", and "contain" used in the description indicate the presence of the stated feature, but do not exclude the presence of one or more other features. The terminology "and/or" used in the description includes any and all combinations of one or more of associated listed items. The terminologies "between X and Y" and "between about X and Y" used in this description should be construed to include X and Y. The terminology "between about X and Y" used in this description means "between about X and about Y", and the terminology "from about X to Y" used in this description means "from about X to about Y".

In the description, when it is stated that an element is "on", "attached" to, "connected" to, "coupled" to, or "contacted" with another element, etc., the element can be directly on, attached to, connected to, coupled to, or contacted with the other element, or an intermediate element may be present. In contrast, when it is stated that an element is "directly on", "directly attached" to, "directly connected" to, "directly coupled" to, or "directly contacted" with another element, no intermediate element will be present. In the description, a feature being arranged to be "adjacent" to another feature may refer to the feature having a portion overlapped with or located above or below the adjacent feature.

In the description, spatial relation terminologies such as "above", "below", "left", "right", "front", "rear", "high", and "low" may describe the relation between one feature and another feature in the accompanying drawings. It should be understood that the spatial relation terminology encompasses different orientations of an equipment in use or operation in addition to the orientation shown in the drawings. For example, when the equipment in the drawings is inverted, the feature originally described to be "below" another feature may be described to be "above" the other feature at this time. The equipment may also be otherwise oriented (rotated 90 degrees or in another orientation), and at this time, the relative spatial relation may be interpreted accordingly.

In the research of the micro-nano device and the production process of the semiconductor chip, the desired device or chip structure is formed typically using the lithography technology based on the mask. In order to form the desired structure, according to the layout of the device or the chip to be processed, one or more masks may be fabricated in advance in the light of corresponding process procedures, wherein the pattern on each mask may correspond to one layer in the layout or to a plurality of layers that can be prepared in a same procedure. Typically, the mask may include the substrate (e.g., quartz glass) which can cause the exposure beam (e.g., ultraviolet light, etc.) for changing the property of the resist (photoresist) to transmit through, and the plated film (e.g., the metal chromium film) deposited on the substrate for preventing the ultraviolet light described above from transmitting through.

In a method of manufacturing the mask, the chromium film with a thickness of several tens of nanometers and the resist positioned on the chromium film may be sequentially deposited on the quartz glass, then the desired pattern may be formed on the resist by means of laser direct writing or electron beam exposure, and then the chromium exposed from the resist may be wet-etched or dry-etched to form the pattern corresponding to the desired structure on the chromium film. The means of laser direct writing is typically used for forming the mask with the minimum linewidth of above 300 nm, and the means of electron beam exposure can be used for forming the mask with the minimum linewidth of less than 300 nm.

Using the above preparation method, the cost of a single sheet of mask is approximately tens of thousands of dollars, and the cost of a complete set of masks for the complete device or chip production process might be up to millions of dollars. Moreover, once such a mask is prepared, its structure is difficult to be altered. In a traditional application scenario, the amount of a single batch of chips, including a central processing unit (CPU), a dynamic random access memory (DRAM), a flash memory and the like, is typically in the order of millions or even hundreds of millions, so that the cost of fabricating the mask can be well shared, and thus, the lithography process based on the mask can be widely applied to the fabrication and production of these devices or chips. However, with the development of industries such as Internet of Things, artificial intelligence, and personalized life health, production of a small-batch of devices or chips is increasingly involved, and the number of these devices or chips might only be tens of thousands or even less. If the mask is prepared in advance and then these devices or chips are produced based on the mask, it is difficult to share the cost of fabricating the mask by a sufficient number of devices or chips, resulting in a great increase in the device or chip cost. In addition, if these devices or chips are directly fabricated by means of laser direct writing, on one hand, the yield is too low to meet the requirement of mass production, and on the other hand, the minimum linewidth of about 300 nm of the laser direct writing also restricts an increase in the integration and performance of the chips and a decrease in the cost of the chips by means of scaling down the devices. Similarly, if these devices or chips are fabricated directly by means of electron beam exposure, although devices or chips with a smaller size and higher integration can be fabricated, their yield is still too low to satisfy the production requirements, and the processing cost is very high, so that market penetration of the devices and chips is hindered.

In addition, the defect present in the mask might also result in a great increase in the cost of producing the devices or chips. Specifically, if a minor defect is present in the mask, time needs to be spent on detection and repair of the defect; and if a major defect is present in the mask, the entire mask might have to be discarded.

In order to solve the above problems, to meet the requirements of production of small-batch chips and development of related products to high integration, and to make the technologies such as future Internet of things and artificial intelligence be able to have better social permeability, the present disclosure provides a programmable, rewritable and reusable digital lithography mask. In such a mask, a light-transmitting state of a corresponding pixel region in the mask can be changed by controlling an ion-bonding state of an electrochromic material in an electrolytic reaction layer, such that a pattern on the same mask can be changed as required, thereby realizing reuse of the mask and further reducing the production cost of devices or chips. The electrochromic material may be bonded with cations or anions, and exhibit non-light-transmitting in the ion-bonding state while exhibit light-transmitting in the ion-debonding state, or exhibit light-transmitting in the ion-bonding state while exhibit non-light-transmitting in the ion-debonding state, which is not limited herein. Hereinafter, various state changes in the mask will be elaborated in detail by taking an example that the electrochromic material is bonded with hydrogen ions and/or lithium ions, but it can be understood that the adjustment of the light-transmitting state in the mask can be also achieved by employing other electrochromic materials and ionic systems.

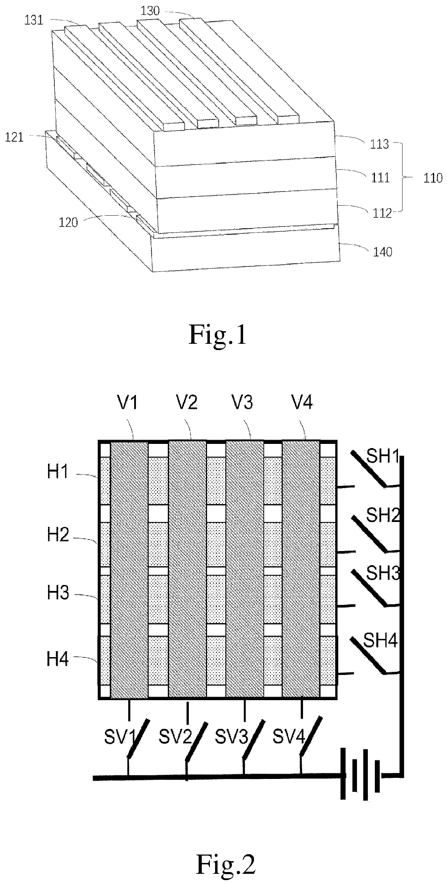

In an exemplary embodiment of the present disclosure, as shown in Fig. 1, the mask may include an electrolytic reaction layer 110, a first control circuit layer 120, and a second control circuit layer 130.

The electrolytic reaction layer 110 may include an electrochromic material whose transmittance may vary with a change in its ion-bonding state. When the electrochromic material is in the non-light-transmitting state, it can block the exposure beam such as ultraviolet light for changing the resist; while when the electrochromic material is in the light-transmitting state, it can make the ultraviolet light or the like for changing the resist transmit through; the transmitted-through ultraviolet light may expose the resist in the corresponding region of the device or chip to help form a desired device or chip structure.

In some embodiments, as shown in Fig.1, the electrolytic reaction layer 110 may include an electrolyte layer 111, a first electrolytic material layer 112, and a second electrolytic material layer 113. In the electrolyte layer 111, at least one of lithium ions or hydrogen ions can be dissolvable, for example. By applying an electric field, the lithium ions and/or hydrogen ions may be made to move in a desired direction in the electrolyte layer 111 and then be bonded with the electrochromic material in the first electrolytic material layer 112 or in the second electrolytic material layer 113, so that the electrochromic material is in the non-light-transmitting state, and a non-light-transmitting region in the mask is formed accordingly. In addition, by applying a reverse electric field, the lithium ions and/or hydrogen ions bonded with the first electrolytic material layer 112 or the second electrolytic material layer 113 may be made to be extracted out and be detached from the first electrolytic material layer 112 or the second electrolytic material layer 113, so that the electrochromic material is in the light-transmitting state, and a light-transmitting region in the mask is formed accordingly.

As shown in Fig. 1, the first electrolytic material layer 112 may be provided between the first control circuit layer 120 and the electrolyte layer 111, and the second electrolytic material layer 113 may be provided between the electrolyte layer 111 and the second control circuit layer 130. Under the joint action of the first and second control circuit layers 120 and 130, the electric field applied to individual pixel region in the electrolytic reaction layer 110 can be controlled, thereby changing the light-transmitting state of the corresponding pixel region, as will be described in detail later.

In some embodiments, the electrolyte layer 111 may be in a solid or liquid state, in other words, the electrolyte layer 111 may include solid electrolyte or liquid electrolyte. In the case where the electrolyte layer 111 is the solid electrolyte, after the electric field applied to the mask is removed, the movement of the ions can be still well restricted, and thus the light-transmitting region and the non-light-transmitting region of the mask can be well maintained. While in the case where the electrolyte layer 111 is the liquid electrolyte, after the electric field applied to the mask is removed, the light-transmitting region and the non-light-transmitting region of the mask may change slowly, and their stability becomes poor accordingly (but it can be appreciated that, even if the stability is poor, it can generally meet the lithograph requirement). At the same time, however, in the case where the electrolyte layer 111 is the liquid electrolyte, in the process of generating the corresponding light-transmitting and non-light-transmitting regions on the mask, the ions may move faster in the liquid electrolyte, and thus be bonded faster with the first electrolytic material layer 112 or the second electrolytic material layers 113, or be detached from the first electrolytic material layer 112 or the second electrolytic material layer 113 faster, so as to achieve switching between the light-transmitting state and the non-light-transmitting state in corresponding regions faster. In practical applications, the corresponding electrolyte layer can be selected according to requirements.

In some embodiments, the first electrolytic material layer 112 and the second electrolytic material layer 113 in the electrolytic reaction layer 110 may be formed using a material that is transmissive to the ultraviolet light or the like for lithography and has certain conductivity, and at least one of the first electrolytic material layer 112 or the second electrolytic material layer 113 is the electrochromic material. In a specific example, the electrochromic material may include magnesium-nickel alloy (Mg-Ni), magnesium-yttrium alloy (Mg-Y), metal oxide such as niobium oxide (NbOₓ) glass or niobium oxide (NbOₓ) glass modified by indium tin oxide (ITO) nanoparticles. The other of the first electrolytic material layer 112 and the second electrolytic material layer 113 may include transition metal oxide, such as wolfram oxide (WO₃). Reversible changes in the light-transmitting state to the ultraviolet light within the waveband of 365~405 nm can be realized using reversible hydrogenation for Mg-Ni or Mg-Y, while reversible changes in the light-transmitting state to the ultraviolet light around 405 nm can be realized using an NbOₓ film material modified by ITO nanoparticles.

In some embodiments, the electrolytic reaction layer 110 may be in a shape of continuous film. Specifically, the electrolyte layer 111 in the electrolytic reaction layer 110 may include the electrolyte material in the shape of continuous film, the first electrolytic material layer 112 may include a first electrolytic material in a shape of continuous film, and the second electrolytic material layer 113 may include a second electrolytic material in a shape of continuous film. The electrolytic reaction layer 110 in the shape of continuous film is easy to be prepared in the mask, and there is no problem of alignment with other components (for example, the first control electrodes 121 in the first control circuit layer 120 and the second control electrodes 131 in the second control circuit layer 130) in the mask in the process of manufacturing the mask, thus the fabrication cost of the mask can be effectively reduced. In addition, by using the material with high resistivity in the electrolytic reaction layer 110, electric field interference between adjacent regions may be avoided, thereby independently controlling the light-transmitting state and the non-light-transmitting state of each region.

However, in some other embodiments, in order to further enhance isolation between individual pixel regions in the mask, to avoid electric field interference between adjacent pixel regions, so that the electrochromic material in each pixel region is only or substantially independently controlled by the electric field applied to the pixel region; one or more layers in the electrolytic reaction layer 110 may be provided as a plurality of blocks arranged in an array (for example, in a rectangular array), and each pixel region in the mask may include one or more adjacent blocks (for example, each pixel region includes one block, or each pixel region includes 2×2, four in total, blocks adjacent to each other, etc.). Specifically, the electrolyte layer 111 may include a plurality of electrolyte material blocks arranged in an array, and each pixel region in the mask may include one or more electrolyte material blocks; and/or the first electrolytic material layer 112 may include a plurality of first electrolytic material blocks arranged in an array, and each pixel region in the mask may include one or more first electrolytic material blocks; and/or the second electrolytic material layer 113 may include a plurality of second electrolytic material blocks arranged in an array, and each pixel region in the mask may include one or more second electrolytic material blocks. However, in this case, in the process of preparing the mask, the problem of alignment among the layers inside the electrolytic reaction layer 110 or the electrolytic reaction layer 110 and other components (for example, the first control electrodes 121 in the first control circuit layer 120 and the second control electrodes 131 in the second control circuit layer 130) in the mask generally needs to be considered, and thus it might cause an increase in the cost of the mask.

As shown in Figs. 1, 2, 3 and 5, in order to control the light-transmitting state of each pixel region in the mask, a control circuit that is similar to a charge coupled device (CCD) driver in a digital camera or a display driving circuit in a display may be adopted. Specifically, the first control circuit layer 120 may be provided on the first side of the electrolytic reaction layer 110, and the first control circuit layer 120 may include a plurality of first control electrodes 121. Similarly, the second control circuit layer 130 may be provided on the second side of the electrolytic reaction layer 110 that is opposite to the first side, and the second control circuit layer 130 may include a plurality of second control electrodes 131. One of the first control electrode 121 and the second control electrode 131 is similar to a scan line in the CCD driving circuit or in the display driving circuit, while the other one of the first control electrode 121 and the second control electrode 131 is similar to a data line in the CCD driving circuit or in the display driving circuit. At least a part of each first control electrode 121 may be overlapped with at least a part of one corresponding second control electrode 131 in a thickness direction of the mask, so that the intersection region of the first control electrode 121 and the second control electrode 131 of the mask may be controlled by the electric field between the first control electrode 121 and the second control electrode 131, that is, the ions in the electrolyte layer 111 at the intersection may move under the action of the electric field; the ions are bonded with the electrochromic material in the first electrolytic material layer 112 or in the second electrolytic material layer 113, or are detached from the electrochromic material in the first electrolytic material layer 111 or in the second electrolytic material layer 113, thereby changing the light-transmitting state at the intersection. In other words, the light-transmitting state of the pixel region in the mask may be configured to be decided by the control voltage between at least a part of the first control electrode 121 and at least a part of the second control electrode 131 contained in the pixel region, or by a loading history of the control voltage between at least a part of the first control electrode 121 and at least a part of the second control electrode 131 contained in the pixel region, the part of the first control electrode 121 and the part of the second control electrode 131 being overlapped in the thickness direction of the mask, the control voltage controlling the light-transmitting state of the pixel region by controlling the ion-bonding state of the electrochromic material in the electrolytic reaction layer 110.

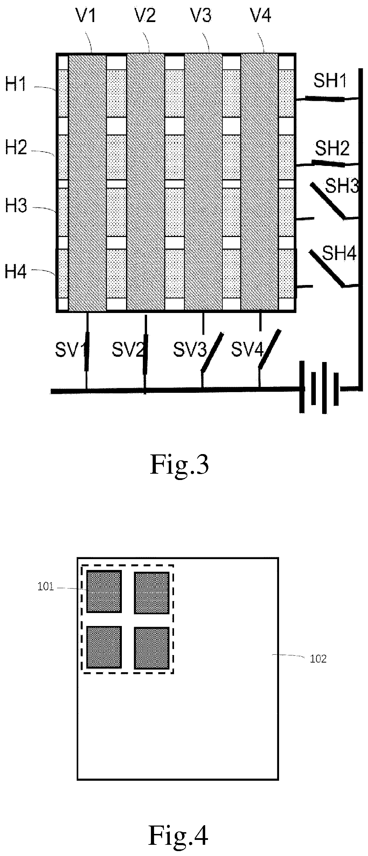

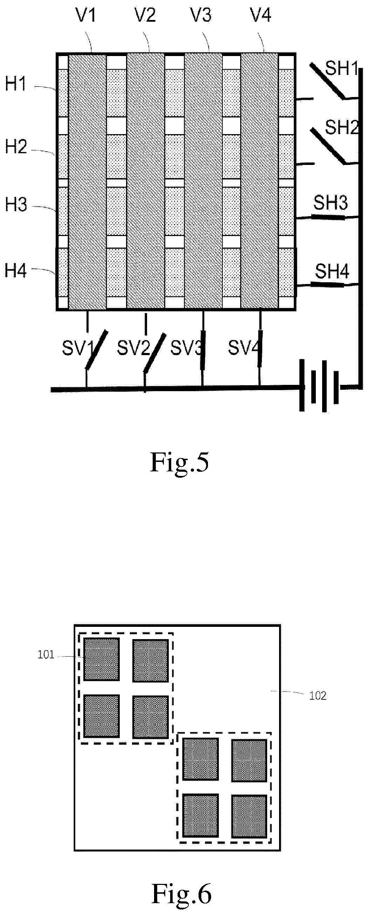

In some embodiments, the region at each intersection may be formed as one pixel region (for example, each minimum shadow region shown in Figs. 4 and 6 may be regarded as one pixel region in the non-light-transmitting state). In other words, each pixel region in the mask may include at least a part of one first control electrode and at least a part of one second control electrode (for example, each pixel region includes a part of the first control electrode and a part of the second control electrode that are overlapped with each other). Alternatively, in some other embodiments, one pixel region may be jointly formed by the regions at a plurality of intersections adjacent to each other (for example, as shown in Figs. 4 and 6, one region including four intersection regions and represented by a dashed box may be regarded as one pixel region in the non-light-transmitting state). In other words, each pixel region in the mask may include at least a part of more than one first control electrodes and at least a part of more than one second control electrodes (for example, include a part of each first control electrode of two first control electrodes and a part of each second control electrode of two second control electrodes).

In some embodiments, as shown in Figs. 2, 3 and 5, each of the plurality of first control electrodes (H1, H2, H3 and H4) may be respectively connected to a first pole (for example, a cathode shown in the figure) of a control power supply via a respective first switching device (SH1, SH2, SH3 and SH4), while each of the plurality of second control electrodes (V1, V2, V3 and V4) may be respectively connected to a second pole (for example, an anode shown in the figure) of the control power supply via a respective second switching device (SV1, SV2, SV3 and SV4). As such, the voltage applied to each control electrode can be controlled by controlling an on or off state of each switching device, and then the light-transmitting state of a respective pixel region in the mask is controlled. Further, as described above, in the electrolytic reaction layer 110, even if the applied external electric field is removed, the bonding or debonding state of the ions with the electrochromic material in a respective region can still be maintained, and thus the light-transmitting state of each pixel region in the mask can be controlled by controlling one or more first switching devices and one or more second switching devices stepwise. The switching device may include a device such as a field effect transistor, which is not limited herein. In some embodiments, the switching devices may be provided jointly in the control circuit layer of the mask. Alternatively, in some other embodiments, the switching device may be provided outside the mask to avoid interference to the light-transmitting state of each pixel region in the mask. As described below, in some embodiments, respective control signals may be applied directly to the control electrodes, thereby omitting the switching devices.

In a specific example, as shown in Figs. 3 to 6, if it is desired to form a non-light-transmitting region shown in Fig. 6 (the shaded part shown in the figure) on the mask, this can be done in two steps.

First, as shown in Fig. 3, by switching on the switching devices SH1, SH2, SV1 and SV2 and switching off the switching devices SH3, SH4, SV3 and SV4, an electric field directing from the second control electrode V1 to the first control electrode H1 is applied onto the intersection region of the first control electrode H1 and the second control electrode V1, and accordingly, hydrogen ions and/or lithium ions in the electrolyte layer 111 of the region will move toward the first control electrode H1 and then being bonded with the electrochromic material in the first electrolytic material layer 112 of the region. As such, the intersection region of the first control electrode H1 and the second control electrode V1 of the mask will be in the non-light-transmitting state. Similarly, the intersection region of the first control electrode H1 and the second control electrode V2, the intersection region of the first control electrode H2 and the second control electrode V1, and the intersection region of the first control electrode H2 and the second control electrode V2 will all be presented in the non-light-transmitting states. In other areas of the mask, however, since the electric field as described above is not formed, the hydrogen ions and/or lithium ions in the electrolyte layer 111 are not bonded with the electrochromic material, so that the electrochromic material is still maintained in the light-transmitting state, thereby the corresponding regions of the mask are in the light-transmitting state. In conclusion, the mask with the pattern as shown in Fig. 4 can be formed.

Then, as shown in Fig. 5, by switching on the switching devices SH3, SH4, SV3 and SV4 and switching off the switching devices SH1, SH2, SV1 and SV2, an electric field directing from the second control electrode V3 to the first control electrode H3 is applied onto the intersection region of the first control electrode H3 and the second control electrode V3, and accordingly, hydrogen ions and/or lithium ions in the electrolyte layer 111 of the region will move toward the first control electrode H3, thereby being bonded with the electrochromic material in the first electrolytic material layer 112 of the region. As such, the intersection region of the first control electrode H3 and the second control electrode V3 of the mask will be in the non-light-transmitting state. Similarly, the intersection region of the first control electrode H3 and the second control electrode V4, the intersection region of the first control electrode H4 and the second control electrode V3, and the intersection region of the first control electrode H4 and the second control electrode V4 will all be presented in the non-light-transmitting states. In other areas of the mask, however, since the electric field as described above is not formed, the ions may be maintained in their original forms, so that the intersection region of the first control electrode H1 and the second control electrode V1, the intersection region of the first control electrode H1 and the second control electrode V2, the intersection region of the first control electrode H2 and the second control electrode V1, and the intersection region of the first control electrode H2 and the second control electrode V2 are still maintained in the non-light-transmitting states, while the remaining regions are maintained in the light-transmitting states. In conclusion, the mask with the pattern as shown in Fig. 6 can be formed.

In some embodiments, in order to achieve automatic control of the pattern on the mask, the first control signal applied onto each first control electrode and the second control signal applied onto each second control electrode may be generated based on one or more mask patterns to be formed. The first and second control signals may be applied onto the first and second control electrodes directly or through respective switching devices (as shown in Figs. 2, 3 and 5). By setting level states of the first and second control signals in each time period, the light-transmitting state of the pixel region that includes at least a part of the first control electrode and at least a part of the second control electrode that are overlapped of the mask can be changed automatically and continuously, and in some cases, the switching devices can be omitted, or changing the on or off state of individual switching device manually can be avoided.

It can be understood that in another specific example, the mask may include more or fewer first and second control electrodes. For example, it is possible to form the first control electrodes with the number of 1000-100000 and the second control electrodes with the number of 1000-100000 on the mask, and then form the pixel regions in the order of 1000×1000~100000×100000, which is not limited herein. Furthermore, in some embodiments, according to different directions of the first and second poles (anode and cathode) of the control power supply, the ions might be bonded with the electrochromic material provided in the second electrolytic material layer 131 to form the non-light-transmitting region, which is not limited herein. Further, according to the desired mask pattern, on or off states of a different number of switching devices connected to different control electrodes may be separately controlled in each step of forming the mask pattern, which is not limited herein.

In addition, when it is necessary to erase or change the pattern on the mask, i.e. to change the light-transmitting states of one or more pixel regions on the mask, so that the mask can be used for preparation of another different structure, the control power supply may be reversed, i.e. the first pole and the second pole (anode and cathode) of the control power supply are exchanged, combined with on or off of respective switching devices, so that the ions bonded with the electrochromic material are detached, and thus the regions are converted into the light-transmitting states.

In order to simplify the structure of the control circuit layer, the light-transmitting state of each pixel region in the mask is controlled using as few switching devices or control signals as possible, as shown in Figs. 1, 2, 3 and 5, the first control electrode 121 may be a first strip electrode extending in a first direction, and a plurality of first control electrodes 121 may be arranged in the first control circuit layer 120 in electrical isolation from each other, so that the voltage applied to each first control electrode 121 can be individually controlled. Similarly, the second control electrode 131 may be a second stripe electrode extending in a second direction perpendicular to the first direction, and a plurality of second control electrodes 131 may be arranged in the second control circuit layer 130 in electrical isolation from each other, so that the voltage applied to each second control electrode 131 can be individually controlled. And by providing the first and second strip electrodes, the intersection region between the first and second control electrodes can be conveniently formed without performing complicated alignment in the process of preparing the mask. However, it can be understood that, in some other embodiments, the control electrodes 131 may be arranged in another form, and the light-transmitting state of each intersection region may be controlled as long as the electric field applied to the overlapping part between the first and second control electrodes 121 and 131 in the thickness direction of the mask can be independently controlled, which is not limited herein. For example, when the mask has a large area, two or more first strip electrodes or second strip electrodes may be provided in a same horizontal or vertical direction, to avoid excessive attenuation of the applied control signal across different regions of the electrode, or the like.

In some embodiments, the ratio of the area of the region occupied by the first control electrodes 121 to the area of the region not occupied by the first control electrodes 121 in the first control circuit layer 120 may be 100%~1000%. Similarly, the ratio of the area of the region occupied by the second control electrodes 131 to the area of the region not occupied by the second control electrodes 131 in the second control circuit layer 130 may be 100%~1000%. On the one hand, the greater the ratio, the greater the area of the region occupied by the control electrodes in the corresponding control circuit layer, thus when the region is set as the non-transparent region, the better the effect of blocking the ultraviolet light can be, especially in the case where one pixel region is formed by the regions at a plurality of intersections, the smaller the gap between adjacent electrodes in the pixel region, the better the light blocking performance. However, due to small spacing between the control electrodes in the same control circuit layer, it might cause an increase in the difficulty in preparing the control electrode array, for example, since a proximity effect or the like causes spacing between adjacent control electrodes to be smaller than the design spacing or be even zero, it causes a short circuit between the adjacent control electrodes, or the like. On the other hand, the smaller the ratio, it helps to reduce the difficulty in the preparation of the control electrode array, but accordingly, when the spacing between the control electrodes in the same control circuit layer is large, the blocking effect on the ultraviolet light might be deteriorated, and especially in the case where one pixel region is formed by a plurality of intersection regions, when it is desired to regulate the pixel region to the non-light-transmitting state, the gap between the control electrodes might cause a certain degree of light leakage.

In some embodiments, the ratio of the area of the region occupied by the first control electrodes 121 to the area of the region not occupied by the first control electrodes 121 in the first control circuit layer 120 may be equal to the ratio of the area of the region occupied by the second control electrodes 131 to the area of the region not occupied by the second control electrodes 131 in the second control circuit layer 130. As such, each intersection region will have substantially the same distribution in the horizontal and vertical directions, which helps to simplify the preparation process of the mask.

In some embodiments, the plurality of first control electrodes 121 in the first control circuit layer 120 may be periodically arranged, and similarly, the plurality of second control electrodes 131 in the second control circuit layer 130 may be periodically arranged. As such, the size of each intersection region or each pixel region may be equal to each other. Further, the arrangement period of the plurality of first control electrodes 121 in the first control circuit layer 120 may be 50 nm~50 µm, similarly, the arrangement period of the plurality of second control electrodes 131 in the second control circuit layer 130 may be 50 nm~50 µm. In a specific example, the arrangement period of the plurality of first control electrodes 121 in the first control circuit layer 120 may be 5 µm, and/or the arrangement period of the plurality of second control electrodes 131 in the second control circuit layer 130 may be 5 µm. It can be appreciated that the smaller the arrangement period of the control electrodes, the higher the pattern accuracy that the mask can achieve, but accordingly, the more difficult the fabrication process of the mask might be, and the higher the fabrication cost might be.

In some embodiments, the arrangement period of the plurality of first control electrodes 121 in the first control circuit layer 120 may be equal to the arrangement period of the plurality of second control electrodes 131 in the second control circuit layer 130. As such, each intersection region will have substantially the same distribution in the horizontal and vertical directions, and it helps simplify the preparation process of the mask.

In order to avoid interference of the control circuit layer to the light-transmitting state of the mask, the first and second control electrodes 121 and 131 may be formed using a material that is transparent to the ultraviolet light and has certain conductivity. For example, in some embodiments, the first control electrode 121 may include at least one of indium tin oxide (ITO), aluminum-doped zinc oxide, conductive diamond, or conductive aluminum nitride (AlN). Similarly, the second control electrode 131 may include at least one of indium tin oxide (ITO), aluminum-doped zinc oxide, conductive diamond, or conductive aluminum nitride (AlN). In some embodiments, the thickness of the first control circuit layer 120 may be 10 nm~100 nm. Similarly, the thickness of the second control circuit layer 130 may be 10 nm~100 nm. In addition, the resistivity of the first control electrode 121 is generally less than that of the electrolytic reaction layer 110, and the resistivity of the second control electrode 131 is also generally less than that of the electrolytic reaction layer 110, so that a desired electric field can be substantially uniformly distributed in the region corresponding to the control electrodes, and interference of the electric field between adjacent intersection regions or pixel regions is avoided. In addition, a total thickness of the electrolytic reaction layer 110, the first control circuit layer 120, and the second control circuit layer 130 may be below 100 µm, to avoid too slow switching between the light-transmitting state and the non-light-transmitting state of the mask due to the excessive thickness.

Furthermore, in some embodiments of the present disclosure, as shown in Fig. 1, the mask may further include a substrate 140, wherein the first control circuit layer 120, the electrolytic reaction layer 110, and the second control circuit layer 130 may be sequentially deposited on the substrate 140. In other words, the substrate 140 may serve as a support for various layers thereon. The substrate 140 may be made of quartz glass, calcium fluoride glass, or the like which is transparent to the ultraviolet light.

In the mask of the present disclosure, the transparent control electrode arrays are utilized to control the bonding states between the ions and the electrochromic material in the electrolytic reaction layer between the control electrode arrays, thereby realizing the reversible adjustment of the light-transmitting state of each pixel region in the mask. As such, the corresponding mask pattern can be directly written and formed based on the data file of the desired device or chip structure, and the mask pattern on the same mask can be erased for reuse of the mask, which improves the use efficiency of the mask, reduces the cost of fabricating the device or chip, and avoids a series of problems caused by overhigh cost of the mask in the traditional lithography. In an exemplary embodiment of the present disclosure, the period of the control electrode array in the control circuit layer may be 100 nm or less, in combination with fourfold (4×) reduced projection exposure, the requirement of 28 nm process node may be satisfied, and in combination with technologies such as Lithography Etch Lithography Etch (LELE) process, the requirement of 14 nm or more advanced process node may be satisfied, and thus reliable and low-cost production of small-batch chips with high integration may be achieved.

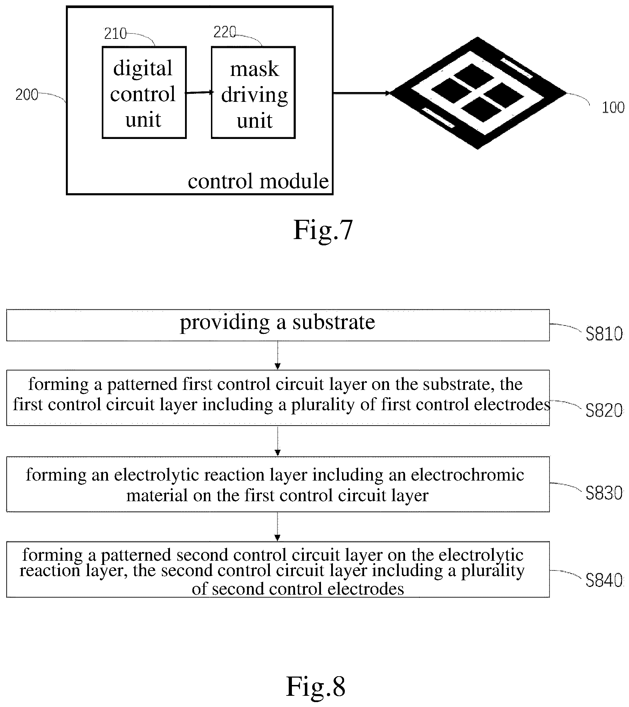

In an exemplary embodiment of the present disclosure, a lithographing apparatus is also provided. As shown in Fig. 7, the lithographing apparatus may include the mask 100 as described above and a control module 200. The control module 200 may be configured to generate, according to a layout, a plurality of first control signals applied to the plurality of first control electrodes 121 and a plurality of second control signals applied to the plurality of second control electrodes 131, respectively, so that the light-transmitting states of the pixel regions in the mask 100 respectively correspond to a respective layer in the layout. Specifically, the control module 200 may include a digital control unit 210 for generating a plurality of mask patterns corresponding to one or more layers in a layout of a device or chip and generating respective first and second control signals according to respective mask patterns, and a mask driving unit 220 for changing the light-transmitting state of each pixel region in the mask according to each set of the first and second control signals, respectively.

In the lithographing apparatus of the embodiment of the present disclosure, if a mask with a linewidth of 100 nm precision is adopted in conjunction with the technologies such as 4x reduced projection and LELE, the area of each exposure can be about 0.25×0.25 mm² by utilizing 10000x10000 pixel regions. Under the condition, the lithographing apparatus can complete exposure of a 1 cm² grade chip within about 10 minutes by 1600 times of controlling and synchronizing the dynamic adjustment and exposure of the mask combining with the positioning of the workpiece stage with 1-2 nm grade. At 32 nm linewidth precision, this exposure speed is over 100 times that of the most advanced electron beam exposure machine. In conclusion, the fabrication of complex devices or chips can be efficiently and accurately completed through only one or a few reusable and rewritable masks, which reduces the cost of fabricating the devices or chips, and facilitates rapid updating, mass production and better market penetration of the devices or chips.

In an exemplary embodiment of the present disclosure, there is also provided a method of manufacturing a mask, which may include, as shown in Fig. 8:
step S810, providing a substrate;
step S820, forming a patterned first control circuit layer on the substrate, the first control circuit layer including a plurality of first control electrodes;
step S830, forming an electrolytic reaction layer including an electrochromic material on the first control circuit layer; and
step S840, forming a patterned second control circuit layer on the electrolytic reaction layer, the second control circuit layer including a plurality of second control electrodes;
wherein a light-transmitting state of a pixel region in the mask is configured to be decided by a control voltage between at least a part of the first control electrode and at least a part of the second control electrode contained in the pixel region, and the control voltage controls the light-transmitting state of the pixel region by controlling the ion-bonding state of the electrochromic material in the electrolytic reaction layer.

In the process of forming the patterned first and second control circuit layers, the patterned first and second control circuit layers may be formed by means of laser direct writing or electron beam direct writing, or may be formed by means of lithography based on another mask. When parameters such as a ratio of an area of a region occupied by control electrodes to an area of a region not occupied by control electrodes, a period of the control electrode array and the like in the first control circuit layer and in the second control circuit layer are the same, the first control circuit layer and the second control circuit layer can be formed in different directions (for example, directions perpendicular to each other) by using the same mask to reduce the fabrication cost.

Further, in some embodiments, forming the electrolytic reaction layer on the first control circuit layer may include:
sequentially laminating a first electrolytic material layer, an electrolyte layer and a second electrolytic material layer together to form the electrolytic reaction layer; and
forming the electrolytic reaction layer on the first control circuit layer, wherein the first electrolytic material layer is located between the first control circuit layer and the electrolyte layer.

When the first electrolytic material layer, the electrolyte layer and the second electrolytic material layer are in a shape of continuous film, the formation of the electrolytic reaction layer in this way will be very simple and low-cost. However, if there is some patterning in the first electrolytic material layer, the electrolyte layer or the second electrolytic material layer, the corresponding patterned layer can be formed by means of laser direct writing, electron beam direct writing or based on another mask. If the first electrolytic material layer, the electrolyte layer and the second electrolytic material layer have the same patterning manner, a complex of the first electrolytic material layer, the electrolyte layer and the second electrolytic material layer may be formed first by laminating and then the complex may be patterned.

Alternatively, in some other embodiments, forming the electrolytic reaction layer on the first control circuit layer may include:
forming the first electrolytic material layer on the first control circuit layer;
forming the electrolyte layer on the first electrolytic material layer; and
forming the second electrolytic material layer on the electrolyte layer.

When the electrolytic reaction layer is formed in this manner, a corresponding material that is in a shape of continuous film or patterned can be conveniently deposited in each layer as needed.

Although exemplary embodiments of the present disclosure have been described, those skilled in the art should appreciate that numerous variations and modifications may be made to the exemplary embodiments of the present disclosure without essentially departing from the spirit and scope of the present disclosure. Therefore, all the variations and modifications are included within the scope of protection of the present disclosure that is defined in the claims. The present disclosure is defined by the appended claims, and equivalents of these claims are also included therein.

## Claims

1. A mask, comprising:
an electrolytic reaction layer comprising an electrochromic material;
a first control circuit layer provided on a first side of the electrolytic reaction layer, and the first control circuit layer comprising a plurality of first control electrodes; and
a second control circuit layer provided on a second side of the electrolytic reaction layer that is opposite to the first side, and the second control circuit layer comprising a plurality of second control electrodes;
wherein a light-transmitting state of a pixel region in the mask is configured to be decided by a control voltage between at least a part of the first control electrode and at least a part of the second control electrode contained in the pixel region, and the control voltage controls the light-transmitting state of the pixel region by controlling an ion-bonding state of the electrochromic material in the electrolytic reaction layer.

2. The mask according to claim 1, further comprising:
a substrate, on which the first control circuit layer, the electrolytic reaction layer, and the second control circuit layer are sequentially deposited.

3. The mask according to claim 2, wherein the substrate comprises at least one of quartz or calcium fluoride.

4. The mask according to claim 1, wherein the electrolytic reaction layer comprises:
an electrolyte layer;
a first electrolytic material layer provided between the first control circuit layer and the electrolyte layer; and
a second electrolytic material layer provided between the electrolyte layer and the second control circuit layer.

5. The mask according to claim 4, wherein at least one of lithium ions or hydrogen ions are dissolvable in the electrolyte layer.

6. The mask according to claim 4, wherein the electrolyte layer comprises solid electrolyte; or
the electrolyte layer comprises liquid electrolyte.

7. The mask according to claim 4, wherein one of the first electrolytic material layer and the second electrolytic material layer comprises the electrochromic material.

8. The mask according to claim 7, wherein one of the first electrolytic material layer and the second electrolytic material layer comprises magnesium nickel alloy, magnesium yttrium alloy, niobium oxide, or niobium oxide modified by indium tin oxide nanoparticles.

9. The mask according to claim 7, wherein another of the first electrolytic material layer and the second electrolytic material layer comprises transition metal oxide.

10. The mask according to claim 9, wherein another of the first electrolytic material layer and the second electrolytic material layer comprises wolfram oxide.

11. The mask according to claim 4, wherein the electrolyte layer comprises an electrolyte material in a shape of a continuous film;
the first electrolytic material layer comprises a first electrolytic material in a shape of a continuous film; and/or
the second electrolytic material layer comprises a second electrolytic material in a shape of a continuous film.

12. The mask according to claim 4, wherein the electrolyte layer comprises a plurality of electrolyte material blocks arranged in an array, and each pixel region in the mask comprises one or more electrolyte material blocks;
the first electrolytic material layer comprises a plurality of first electrolytic material blocks arranged in an array, and each pixel region in the mask comprises one or more first electrolytic material blocks; and/or
the second electrolytic material layer comprises a plurality of second electrolytic material blocks arranged in an array, and each pixel region in the mask comprises one or more second electrolytic material blocks.

13. The mask according to claim 1, wherein each of the plurality of first control electrodes is respectively connected to a first pole of a control power supply via a respective first switching device; and
each of the plurality of second control electrodes is respectively connected to a second pole of the control power supply via a respective second switching device.

14. The mask according to claim 1, wherein each first control electrode is respectively configured to receive a first control signal, and each second control electrode is respectively configured to receive a second control signal, to control the light-transmitting state of the pixel region containing at least a part of the first control electrode and at least a part of the second control electrode that are overlapped.

15. The mask according to claim 1, wherein the first control electrode is a first strip electrode extending in a first direction, and the plurality of first control electrodes are arranged in the first control circuit layer in electrical isolation from each other; and
the second control electrode is a second strip electrode extending in a second direction perpendicular to the first direction, and the plurality of second control electrodes are arranged in the second control circuit layer in electrical isolation from each other.

16. The mask according to claim 15, wherein each pixel region in the mask comprises at least a part of one first control electrode and at least a part of one second control electrode.

17. The mask according to claim 15, wherein each pixel region in the mask comprises at least a part of more than one first control electrodes and at least a part of more than one second control electrodes.

18. The mask according to claim 15, wherein a ratio of an area of a region occupied by the first control electrodes to an area of a region not occupied by the first control electrodes in the first control circuit layer is 100%~1000%; and/or
a ratio of an area of a region occupied by the second control electrodes to an area of a region not occupied by the second control electrodes in the second control circuit layer is 100%~1000%.

19. The mask according to claim 15, wherein the ratio of the area of the region occupied by the first control electrodes to the area of the region not occupied by the first control electrodes in the first control circuit layer is equal to the ratio of the area of the region occupied by the second control electrodes to the area of the region not occupied by the second control electrodes in the second control circuit layer.

20. The mask according to claim 15, wherein the plurality of first control electrodes in the first control circuit layer are periodically arranged; and/or
the plurality of second control electrodes in the second control circuit layer are periodically arranged.

21. The mask according to claim 20, wherein an arrangement period of the plurality of first control electrodes in the first control circuit layer is 50 nm~50 µm; and/or
an arrangement period of the plurality of second control electrodes in the second control circuit layer is 50 nm~50 µm.

22. The mask according to claim 20, wherein the arrangement period of the plurality of first control electrodes in the first control circuit layer is equal to the arrangement period of the plurality of second control electrodes in the second control circuit layer.

23. The mask according to claim 1, wherein the first control electrode comprises at least one of indium tin oxide, aluminum-doped zinc oxide, conductive diamond, or conductive aluminum nitride; and/or
the second control electrode comprises at least one of indium tin oxide, aluminum-doped zinc oxide, conductive diamond, or conductive aluminum nitride.

24. The mask according to claim 1, wherein a thickness of the first control circuit layer is 10 nm~100 nm; and/or
a thickness of the second control circuit layer is 10 nm~100 nm.

25. The mask according to claim 1, wherein a resistivity of the first control electrode is less than that of the electrolytic reaction layer; and
a resistivity of the second control electrode is less than that of the electrolytic reaction layer.

26. The mask according to claim 1, wherein a total thickness of the electrolytic reaction layer, the first control circuit layer, and the second control circuit layer is below 100 µm.

27. A lithographing apparatus comprising:
a mask according to any one of claims 1 to 26; and
a control module configured to generate, according to a layout, a plurality of first control signals applied to the plurality of first control electrodes and a plurality of second control signals applied to the plurality of second control electrodes respectively, so that light-transmitting states of pixel regions in the mask correspond to the layout.

28. A method for manufacturing a mask, comprising:
providing a substrate;
forming a patterned first control circuit layer on the substrate, the first control circuit layer comprising a plurality of first control electrodes;
forming an electrolytic reaction layer comprising an electrochromic material on the first control circuit layer; and
forming a patterned second control circuit layer on the electrolytic reaction layer, the second control circuit layer comprising a plurality of second control electrodes;
wherein a light-transmitting state of a pixel region in the mask is configured to be decided by a control voltage between at least a part of the first control electrode and at least a part of the second control electrode contained in the pixel region, and the control voltage controls the light-transmitting state of the pixel region by controlling an ion-bonding state of the electrochromic material in the electrolytic reaction layer.

29. The method according to claim 28, wherein forming the electrolytic reaction layer on the first control circuit layer comprises:
sequentially laminating a first electrolytic material layer, an electrolyte layer and a second electrolytic material layer together to form the electrolytic reaction layer; and
forming the electrolytic reaction layer on the first control circuit layer, wherein the first electrolytic material layer is located between the first control circuit layer and the electrolyte layer.

30. The method according to claim 28, wherein forming the electrolytic reaction layer on the first control circuit layer comprises:
forming a first electrolytic material layer on the first control circuit layer;
forming an electrolyte layer on the first electrolytic material layer; and
forming a second electrolytic material layer on the electrolyte layer.
